(19) Europäisches Patentamt / European Patent Office / Office européen des brevets

(11) **EP 3 635 753 B1**

(12) **FASCICULE DE BREVET EUROPEEN**

(45) Date de publication et mention de la délivrance du brevet:
**04.08.2021 Bulletin 2021/31**

(21) Numéro de dépôt: **18728391.6**

(22) Date de dépôt: **04.06.2018**

(51) Int Cl.:
*G01R 31/11* (2006.01)   *H02H 3/04* (2006.01)
*H01B 7/32* (2006.01)   *H02H 1/00* (2006.01)
*G01R 31/08* (2020.01)   *H02H 7/26* (2006.01)
*G02B 6/44* (2006.01)   *H01B 9/00* (2006.01)
*H02H 3/087* (2006.01)   *H02H 7/22* (2006.01)
*G01R 15/24* (2006.01)

(86) Numéro de dépôt international:
**PCT/EP2018/064576**

(87) Numéro de publication internationale:
**WO 2018/224424 (13.12.2018 Gazette 2018/50)**

(54) **DISPOSITIF DE DETECTION DE COURT CIRCUIT, DISPOSITIF DE PROTECTION ET PROCEDE ASSOCIE POUR RESEAU HAUTE TENSION A COURANT CONTINU BASÉ SUR L'EFFET FARADAY**

VORRICHTUNG ZUR ERKENNUNG EINES KURZSCHLUSSES, SCHUTZVORRICHTUNG UND ZUGEHÖRIGES VERFAHREN FÜR EIN HOCHSPANNUNGSGLEICHSTROMNETZ

DEVICE FOR DETECTING A SHORT CIRCUIT, PROTECTION DEVICE AND ASSOCIATED METHOD FOR A HIGH-VOLTAGE DC NETWORK

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **06.06.2017 FR 1754987**

(43) Date de publication de la demande:
**15.04.2020 Bulletin 2020/16**

(73) Titulaire: **Supergrid Institute**
**69100 Villeurbanne (FR)**

(72) Inventeurs:
• **ISMAIL, Boussaad**
  **69372 Lyon cedex 08 (FR)**
• **COURBON, Eric**
  **69372 Lyon cedex 08 (FR)**
• **TUNDO, Alessandro**
  **69372 Lyon cedex 08 (FR)**
• **BOYER, Ludovic**
  **69372 Lyon cedex 08 (FR)**
• **POULAIN, Serge**
  **69372 Lyon cedex 08 (FR)**
• **BERTINATO, Alberto**
  **69372 Lyon cedex 08 (FR)**
• **CALLARI, Fabrizio**
  **69372 Lyon cedex 08 (FR)**

(74) Mandataire: **Opilex**
  **32, rue Victor Lagrange**
  **69007 Lyon (FR)**

(56) Documents cités:
**DE-A1- 19 544 778     FR-A1- 2 687 830**

EP 3 635 753 B1

# Description

Le domaine de la présente invention est relatif au transport d'électricité dans les réseaux de transport à courant continu à haute tension (High Voltage Direct Current (HVDC) en anglais) et plus particulièrement à un dispositif de protection d'un câble HVDC des courts-circuits, ainsi qu'aux procédés de détection et de protection associés, permettant de détecter un défaut au niveau dudit câble de transport d'énergie électrique et sa mise hors tension.

Le développement actuel des énergies renouvelables provoque de nouvelles contraintes au niveau du réseau électrique car les différents lieux de production d'électricité sont généralement éloignés les uns des autres et éloignés des zones de consommation. Il apparaît donc nécessaire de développer de nouveaux réseaux de transport capables de transporter de l'électricité sur de très longues distances tout en minimisant les pertes d'énergie.

Pour répondre à ces contraintes, les réseaux haute tension (par exemple 320kV) à courant continu (High Voltage Direct Curent (HVDC) en anglais) apparaissent comme une solution prometteuse du fait de pertes en ligne inférieures aux réseaux à courant alternatif et d'absence d'incidence des capacités parasites du réseau sur de longues distances.

Cependant, dans de tels réseaux HVDC, notamment dans le cas de réseaux multipoints ou multinœuds, en cas de court-circuit sur l'une des lignes, le défaut se propage très rapidement dans tout le système et le courant de court-circuit peut atteindre plusieurs dizaines de kA en quelques millisecondes et dépasser le pouvoir de coupure des disjoncteurs HVDC qui est généralement limité à environ 15kA.

Le document FR2687830 décrit un dispositif de détection de dépassement de température et la localisation dans un câble de transport d'énergie en utilisant une fibre optique s'étendant le long du câble.

Le document DE19544778 décrit un dispositif de détection d'un courant de court-circuit dans un câble de transport d'énergie en utilisant un capteur optique concentré à simple ou double canal et formés à l'extérieur du câble.

Il convient donc d'établir une stratégie de protection fiable et rapide permettant de détecter un défaut, de le localiser et d'interrompre localement la ligne en défaut pour éviter toute propagation au reste du réseau et éviter également une mise hors tension d'une grande partie du réseau.

A cet effet, la présente invention concerne un dispositif de détection selon la revendication 1.

Le dispositif selon l'invention, en ayant deux détecteurs, un à chaque extrémité du câble, permet de détecter plus rapidement le court-circuit par effet Faraday, et augmente ainsi les chances de couper l'alimentation du câble avant la propagation du câble au-delà dudit câble.

Le dispositif selon l'invention peut présenter en outre une ou plusieurs des caractéristiques suivantes, prises seules ou en combinaison.

Le premier, respectivement le deuxième, dispositif d'interruption peut également être configuré pour interrompre la connexion du câble de transport d'énergie électrique en l'absence de réception d'un signal optique par le premier détecteur optique, respectivement par le deuxième détecteur optique.

Le premier émetteur optique peut être configuré pour transmettre un signal à une première longueur d'onde et le deuxième émetteur optique est configuré pour transmettre un signal à une deuxième longueur d'onde distincte de la première longueur d'onde.

Le dispositif peut comprendre également :

- un premier détecteur de courant disposé à la première extrémité du câble de transport d'énergie électrique et configuré pour détecter un signal de défaut électrique transmis par le câble de transport d'énergie électrique,

- une première unité de traitement disposée à la première extrémité du câble de transport d'énergie électrique et couplée au premier détecteur optique et au premier détecteur de courant et configurée pour déterminer d'une part une direction du signal de défaut électrique reçu et d'autres part un décalage temporel entre l'instant de réception du signal de défaut électrique et l'instant de réception du signal de défaut optique et pour localiser une zone de défaut à partir de la direction du signal de défaut électrique et de l'instant de réception des signaux de défaut optiques et électriques,

- un deuxième détecteur de courant disposé à la deuxième extrémité du câble de transport d'énergie électrique et configuré pour détecter un signal de défaut électrique transmis par le câble de transport d'énergie électrique,

- une deuxième unité de traitement disposée à la deuxième extrémité du câble de transport d'énergie électrique et couplée au deuxième détecteur optique et au deuxième détecteur de courant et configurée pour déterminer d'une part une direction du signal de défaut électrique reçu et d'autres part un décalage temporel entre l'instant de réception du signal de défaut électrique et l'instant de réception du signal de défaut optique et pour localiser une zone de défaut à partir de la direction du signal de défaut électrique et de l'instant de réception des signaux de défaut optiques et électriques.

La zone de détection peut se situer au niveau d'un tronçon du câble de transport d'énergie électrique.

La zone de détection peut se situer au niveau d'une jonction du câble de transport d'énergie électrique.

Le pas d'enroulement des spires de la fibre optique peut avoir une longueur égale à au moins trois fois le diamètre de l'enveloppe isolante sur laquelle est enroulée la fibre optique.

La longueur d'un enroulement de la fibre optique à l'intérieur de l'écran métallique peut être comprise entre 100 et 2000 mètres.

Un enroulement de la fibre optique peut comprendre au moins 80 spires.

Une pluralité d'enroulements de la fibre optique peut être ménagée sur une pluralité de tronçons du câble de transport d'énergie électrique, deux enroulements successifs de la fibre optique étant séparés d'une distance comprise entre 10 et 300 kilomètres.

Il peut comprendre une première fibre optique avec une première pluralité d'enroulements et une seconde fibre optique avec une seconde pluralité d'enroulements, les enroulements de la première fibre optique étant décalés d'une distance prédéfinie des enroulements de la seconde fibre optique.

La fibre optique peut être une fibre monomode.

Il peut comprendre une pluralité de tronçons de câble de transport d'énergie électriques, deux tronçons de câble de transport d'énergie consécutifs étant reliés entre eux par des jonctions et certains premiers tronçons comprennant des enroulements de fibre optique entre l'enveloppe isolante et l'écran métallique sur toute leur longueur.

Dans des deuxièmes tronçons, la fibre optique peut être disposée à l'extérieur de l'écran métallique.

Dans des deuxièmes tronçons, la fibre optique peut être disposée à l'intérieur de l'écran métallique avec un pas d'enroulement au moins 10 fois plus grand que pour les premiers tronçons.

Dans des deuxièmes tronçons, la fibre optique peut être disposée à l'intérieur de l'écran métallique sans s'enrouler autour de l'âme centrale conductrice électriquement, notamment avec des ondulations.

L'invention se rapporte aussi au procédé de détection associé d'un défaut de court-circuit dans un réseau haute tension à courant continu, le réseau comprenant au moins un dispositif de détection tel que précédemment mentionné, ledit procédé comprenant les étapes suivantes :

- on transmet un signal optique polarisé entre au moins une première et une deuxième extrémité du câble de transport d'énergie électrique,
- on détecte si la variation de l'angle de polarisation du signal optique transmis est supérieure à une valeur prédéterminée correspondant à l'apparition d'un courant de court-circuit.

L'invention se rapporte aussi au procédé de protection selon la revendication 17.

D'autres caractéristiques et avantages de l'invention ressortiront de la description suivante, donnée à titre d'exemple et sans caractère limitatif, en regard des dessins annexés sur lesquels :

- la figure 1A représente un schéma d'une section d'un câble de transport d'énergie électrique selon un premier mode de réalisation de la présente invention,
- la figure 1B représente un schéma d'une section d'un câble de transport d'énergie électrique selon un deuxième mode de réalisation de la présente invention,
- la figure 2 représente un schéma d'une partie interne d'un câble de transport d'énergie électrique selon la présente invention,
- la figure 3A représente un schéma d'un câble de transport d'énergie électrique comprenant différents tronçons,
- la figure 3B représente un tronçon de câble sans détection d'un défaut de court-circuit,
- la figure 3C représente un mode de réalisation une jonction pour câble de transport d'énergie électrique,
- la figure 4 représente un schéma d'un câble de transport d'énergie électrique et l'apparition d'un court-circuit au niveau du câble de transport d'énergie électrique,
- la figure 5 représente un schéma d'un dispositif de détection et des signaux détectés aux extrémités d'un câble lors d'un court-circuit,
- la figure 6 représente un schéma d'un dispositif de détection avec un court-circuit au niveau d'un premier endroit,
- la figure 7 représente un graphique des courants mesurés par un détecteur optique et un détecteur de courant au cours du temps dans le cas du court-circuit de la figure 6,
- la figure 8 représente un schéma d'un dispositif de détection avec un court-circuit au niveau d'un deuxième endroit,
- la figure 9 représente un graphique des courants mesurés par un détecteur optique et un détecteur de courant au cours du temps dans le cas du court-circuit de la figure 8,
- la figure 10 représente un organigramme des étapes du procédé de localisation d'un défaut, et
- la figure 11 montre un autre mode de réalisation avec deux fibres optiques dont les enroulements sont décalés.

Sur toutes les figures, les éléments ayant des fonctions identiques portent les mêmes numéros de référence.

Les réalisations suivantes sont des exemples. Bien que la description se réfère à un ou plusieurs modes de réalisation, ceci ne signifie pas nécessairement que chaque référence concerne le même mode de réalisation, ou que les caractéristiques s'appliquent seulement à un seul mode de réalisation. De simples caractéristiques de différents modes de réalisation peuvent également être combinées ou interchangées pour fournir d'autres réalisations.

Par « amont » ou « aval », on situe les éléments dans le sens de propagation d'un défaut de court-circuit. Ainsi, un premier équipement ou élément est situé en amont d'un deuxième équipement ou élément si le défaut de court-circuit traverse d'abord le premier puis le second équipement.

La présente invention concerne un câble de transport d'énergie électrique destiné à être utilisé dans un réseau haute tension à courant continu (High voltage Direct Current (HVDC) en anglais) pour le transport d'énergie électrique, c'est-à-dire du courant.

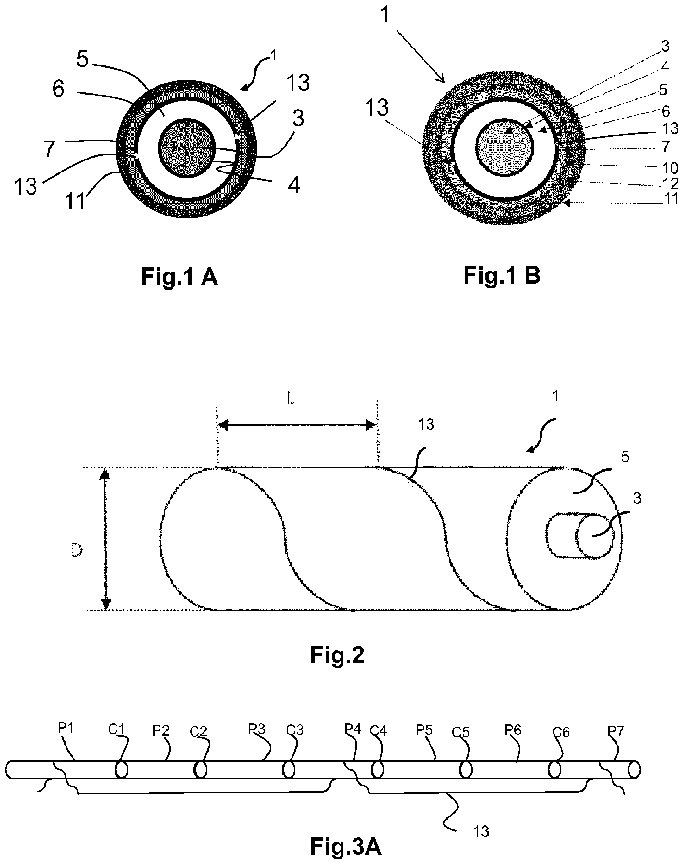

La figure 1A représente un schéma d'une section d'un câble de transport d'énergie électrique 1 selon un premier mode de réalisation de la présente invention et la figure 2 représente un schéma d'une partie interne d'un tel câble de transport d'énergie électrique 1. Ce premier mode de réalisation peut être utilisé pour des réseaux terrestres.

Le câble de transport d'énergie électrique 1 comprend une âme centrale 3 réalisée par un conducteur électrique, par exemple du cuivre ou de l'aluminium, configurée pour transmettre un courant électrique. Autour de l'âme centrale est disposée une isolation semi-conductrice intérieure 4. Le câble de transport d'énergie électrique 1 comprend également une enveloppe 5 isolante électriquement, par exemple en polyéthylène réticulé ou autre matériaux plastique, disposée autour de l'âme conductrice 3 et l'isolation semi-conductrice intérieure 4.

Une isolation semi-conductrice extérieure 6 est disposée autour de l'enveloppe isolante 5. Le câble de transport d'énergie électrique 1 comprend également un écran métallique 7, aussi appelé fourreau, disposé autour de la partie isolante. Cet écran métallique empêche l'émission du champ électromagnétique généré par un courant traversant l'âme centrale 3 à l'extérieur du câble de transport d'énergie électrique et sert aussi à l'évacuation du courant de court-circuit. L'écran métallique 7 est par exemple réalisé en aluminium ou cuivre ou plomb et joue donc le rôle de cage de Faraday. Enfin une gaine externe de protection 11 est disposée autour de l'écran métallique 7.

La figure 1B montre un deuxième mode de réalisation d'un câble de transport d'énergie électrique 1 qui est plutôt destiné à une application sous-marine. Ce mode de réalisation se distingue de celui de la figure 1A en particulier par le fait que l'écran métallique 7 sous forme d'un fourreau est réalisé en plomb et que entre l'écran métallique 7 et la gaine de protection externe 11 est disposée une couche intermédiaire 10 ainsi qu' une armure métallique d'acier 12.

De plus, le câble de transport d'énergie électrique 1 comprend au moins une fibre optique 13 (deux fibres optiques 13 sont représentées sur les figures 1A et 1B, mais on peut également envisager un nombre plus important de fibres) s'étendant le long du câble de transport d'énergie électrique.

Dans au moins une zone de détection du câble de transport d'énergie électrique 1, la fibre optique 13 est disposée entre l'âme centrale 3 conductrice électriquement et l'écran métallique 7 en formant des enroulements autour de l'âme centrale 3.

Plus spécifiquement, la fibre optique 13 est disposée entre l'enveloppe isolante 5 et l'écran métallique 7, sur au moins un tronçon du câble de transport d'énergie électrique 1. Sur ce tronçon, la fibre optique 13 est enroulée sous forme de spires autour de l'enveloppe isolante 5. Ainsi, la fibre optique 13 est exposée au champ électromagnétique émis par un courant traversant l'âme centrale 3, ce qui n'est pas le cas de câbles de transport d'énergie électrique de l'état de la technique où la fibre optique, utilisée pour la communication ou la mesure de la température du câble, est disposée à l'extérieur de l'écran métallique 7, entre celui-ci et la gaine de protection 11. Aux endroits où la fibre optique 13 est enroulée autour de l'âme centrale tout en étant disposée en dessous de l'écran métallique 7, on définit ainsi une zone de détection.

En effet, étant donné que la fibre optique 13 est enroulée autour de l'enveloppe isolante 5 et donc exposée au champ électromagnétique émis par l'âme centrale 3, il devient possible de détecter une variation de courant par l'utilisation de l'effet Faraday au niveau d'un signal optique traversant la fibre optique 13, cette variation de courant étant liée notamment à un défaut de court-circuit au niveau de l'âme conductrice 3. Cette détection basée sur l'effet Faraday sera mieux décrite dans la suite de la description.

Les câbles de transport d'énergie électrique 1 peuvent avoir des longueurs de plusieurs centaines de kilomètres en fonction des besoins de distribution de l'énergie électrique. Toutefois, pour des raisons de montage et pour couvrir de longues distances, on utilise des tronçons de câbles de transport d'énergie électrique, par exemple pour les câbles terrestres d'une longueur comprise entre 500m et 2000m, typiquement 700m qui sont mis bout à bout à l'aide de jonctions par exemple des boîtes de jonction ou des jonctions de câbles spécifiques pour les câbles sous-marins.

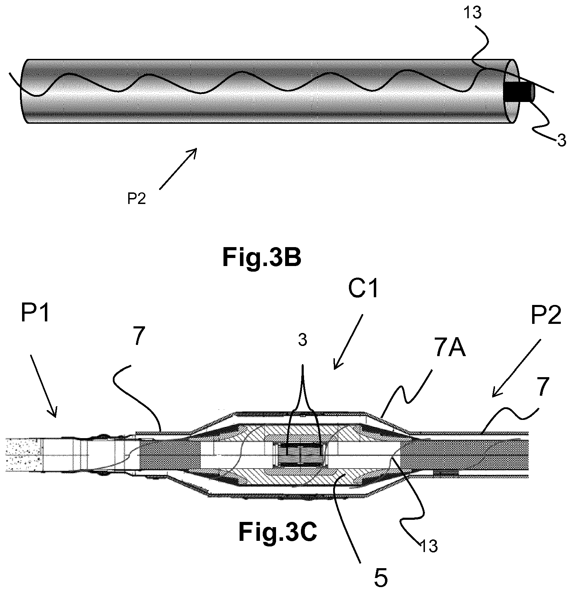

Ceci est représenté de façon schématique sur la figure 3A où le câble de transport d'énergie électrique 1 est divisé en une pluralité de tronçons notés P1, P2...P7 reliés entre eux par des jonctions C1, C2 ... C6 (représentées de façon schématique). Certains tronçons, dans le présent cas les tronçons P1, P4 et P7 comprennent un voire plusieurs enroulement(s) de fibre optique 13 à l'intérieur du cylindre défini par l'écran métallique 7 (non représenté sur la figure 3). La zone de détection se situe au niveau d'un tronçon et peut être formée par un tronçon complet ou par une portion d'un tronçon seulement.

Concernant les autres tronçons P2, P3, P5 et P6, la fibre optique 13 est disposée de manière qu'un signal optique circulant dans ces tronçons P2, P3, P5 et P6 n'est pas ou peu sensible à l'effet Faraday. Ceci est obtenu par exemple en disposant la fibre optique 13 à l'extérieur de l'écran métallique 7 du même câble de transport d'énergie électrique 1, notamment sous forme de câble optique externe. Dans le mode de réalisation de la figure 1A, la fibre optique 13 pourrait être disposée entre l'écran métallique 7 et la gaine protectrice 11. Dans le mode de réalisation de la figure 1B, la fibre optique 13 pourrait être disposée par exemple entre l'écran métallique 7 et l'armature 12 du câble de transport d'énergie électrique 1.

Dans une autre variante, intéressante notamment pour les câble sous-marins, la fibre optique 13 est aussi disposée à l'intérieur du cylindre défini par l'écran métallique 7, mais avec un pas d'enroulement plus grand, notamment 10 fois plus grand par rapport par rapport aux tronçons P1, P4 et P7 de sorte que la fibre 13 de ces tronçons P2, P3 P5 et P6 est très peu sensible à l'effet Faraday sur les signaux optiques la traversant.

Selon encore une autre variante, dans les tronçons P2, P3 P5 et P6 où on ne souhaite pas de détection d'un défaut de court-circuit, la fibre optique 13 est disposée à l'intérieur ou à l'extérieur de l'écran métallique, mais sans s'enrouler autour de l'âme centrale 3 conductrice électriquement, ceci notamment avec des ondulations sur l'écran métallique 7 ou sur l'enveloppe isolante 5. Ceci est représenté sur la figure 3B pour un tronçon P2. Dans ce cas, comme il n'y a pas d'enroulement complet autour de l'âme centrale conductrice 3, l'effet Faraday ne peut pas opérer sur le signal optique circulant dans la fibre optique pour modifier la polarisation du signal optique.

Par ailleurs, d'autres fibres optiques non représentées pour la transmission de signaux optiques de communication peuvent être prévues entre l'écran métallique 7 d'une part et la gaine externe de protection 11 du câble de transport d'énergie électrique aussi bien dans le mode de réalisation de la figure 1A que celui de la figure 1B de sorte que ces fibres ne soient pas sensibles à l'effet Faraday en cas de court-circuit. Lors de la fabrication d'un câble de transport 1 par tronçons, les fibres optiques 13 pour la détection des défauts de courant sont par exemple aussi reliées d'un tronçon à un autre au niveau des jonctions C1 à C6. Pour des applications terrestres, les jonctions peuvent se faire aussi au niveau de chambres de jonction.

En variante à la figure 3A, on peut également prévoir que les enroulements autour de l'âme centrale conductrice 3 soient situés au niveau d'une jonction, par exemple C1, C3 ou C6.

La figure 3C montre à titre d'exemple et de façon schématique et simplifiée une jonction C1 entre deux tronçons P1 et P2 d'un câble par exemple sous-marin.

Pendant la réalisation de la jonction C1, après la connexion des âmes centrales conductrices 3 des deux tronçons P1 et P2 à relier et le placement d'une enveloppe isolante 5 autour, la fibre optique 13 est enroulée autour de l'enveloppe isolante 5 avec un pas défini. La connexion des écrans métalliques 7 des deux tronçons P1 et P2 est assurée par un corps de jonction contenant un écran métallique 7A et qui est positionné dans une étape postérieure à celle de l'enroulement de la fibre optique 13 de telle sorte à ce que la fibre optique 13 soit placée sous l'écran métallique 7A du corps de jonction. L'écran métallique 7A du corps de jonction est finalement protégé par une gaine thermo-rétractable et autre protection mécanique. Dans ce cas la zone de détection se situe au niveau d'une jonction par exemple C1, C3 ou C6.

Les fibres optiques 13 des tronçons P1, P4 et P7 (ou de façon alternative des jonctions C1, C3 ou C6) peuvent alors contribuer à une détection des défauts de courant par utilisation de l'effet Faraday.

Pour cela, un enroulement comprend un nombre donné de spires de fibres optiques 13 pour chaque tronçon P1, P4 et P7 ou jonction C1, C3 ou C6 (par exemple 80) pour que l'effet Faraday soit suffisant important pour permettre une détection d'un courant de court-circuit.

De plus, les fibres optiques 13 peuvent être mises dans de tube rempli de gel pour protéger les fibres optiques 13 de l'humidité et recouvertes par un ou plusieurs ruban semi-conducteur disposé autour des fibres optiques 13.

Les enroulements de fibre optique 13 peuvent être réalisés avec un pas de bobinage L égal à au moins trois fois, par exemple quatre fois, le diamètre D de l'enveloppe isolante 5 de manière à limiter les torsions de la fibre optique 13 et à améliorer la détection réalisée par la fibre optique 13 qui va être décrite plus en détails dans la suite de la description. Le diamètre D de l'enveloppe isolante 5 est par exemple de 10 cm et le pas L d'environ 40 cm. Ainsi, un tronçon P1, P4, P7 de câble de transport d'énergie électrique 1 de 700 mètres comprend par exemple entre 1500 et 1800 spires. Deux tronçons de câble de transport d'énergie électrique 1 comprenant des enroulements de spires de la fibre optique 13 à l'intérieur de l'écran métallique 7 sont par exemple distants de 10 à 300 kms. La distance entre deux enroulements dépend de la précision recherchée dans la localisation d'un défaut de court-circuit.

En effet, les enroulements de spires autour de l'enveloppe isolante 5 permettent de créer des détecteurs de défaut de court-circuit intégrés dans le câble de transport d'énergie électrique 1. Cette détection est basée sur l'effet Faraday qui fait que l'induction créée par un courant transmis dans un conducteur fait tourner l'angle de polarisation d'un signal optique transmis à travers la fibre optique 13. La valeur de ce décalage angulaire $\Delta\theta$ de l'angle de polarisation est donnée par l'équation suivante :

$$\Delta\theta = V*N*I*\cos(\alpha)$$

avec V la constante de Verdet qui dépend du matériau optique dans lequel le signal optique est transmis (cette constante est de l'ordre de $10^{-6}$ rad/A pour la silice), N le nombre de spires de fibre optique 13 autour du conducteur, I la valeur du courant et $\alpha$ l'angle entre le plan des spires et l'axe du conducteur, c'est-à-dire l'axe du câble de transport d'énergie électrique 1 dans le cas présent. Le pas L du bobinage permet d'avoir un angle $\alpha$ différent de 90° qui annulerait le décalage angulaire $\Delta\theta$ lié à l'effet Faraday.

En pratique, la survenue d'un défaut de court-circuit, par exemple un court-circuit dans une section du câble de transport d'énergie électrique 1, provoque l'apparition d'un courant de court-circuit de valeur élevée qui se propage rapidement dans le câble de transport d'énergie électrique 1 et dans les deux directions.

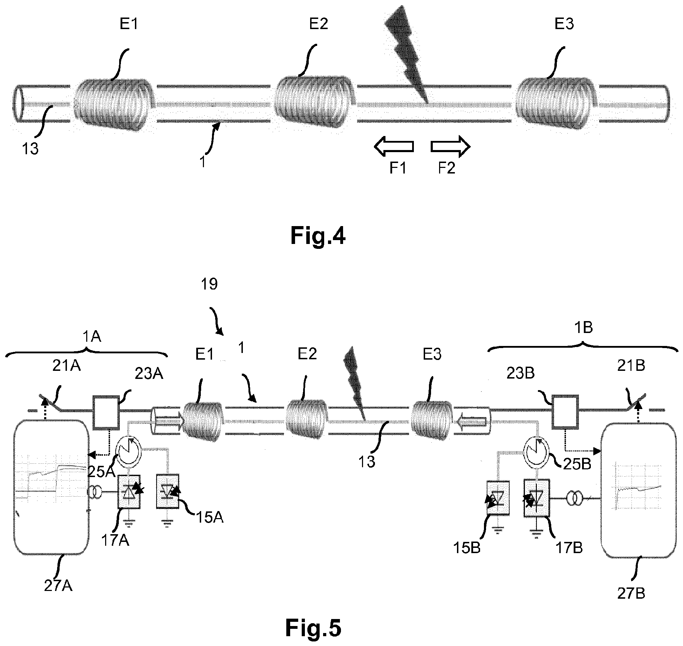

La figure 4 représente un exemple d'un câble de transport d'énergie électrique 1 comprenant trois enroulements distincts de fibre optique 13 notés E1, E2 et E3 et l'apparition d'un défaut représenté par un éclair dans le câble de transport d'énergie électrique 1 entre le deuxième enroulement E2 et le troisième enroulement E3. La direction de propagation du courant de court-circuit est représenté par les flèches F1 et F2.

Pour permettre une détection du défaut avant sa transmission jusqu'aux extrémités 1A et 1B du câble de transport d'énergie électrique 1 (voir figure 5) et donc sa propagation vers les autres équipements du réseau électrique, des émetteurs optiques 15A, 15B et des détecteurs optiques 17A, 17B sont disposés à chaque extrémité 1A et 1B du câble de transport d'énergie électrique 1 pour former, avec le câble de transport d'énergie électrique 1, un dispositif de détection 19.

La figure 5 représente un schéma d'un dispositif de détection 19. Un premier émetteur optique 15A et un premier détecteur optique 17A sont disposés à une première extrémité 1A du câble de transport d'énergie électrique 1. Le premier émetteur optique 15A est configuré pour transmettre un signal optique dans une fibre optique 13 vers la deuxième extrémité 1B du câble de transport d'énergie électrique 1 et un deuxième détecteur optique 17B associé au premier émetteur optique 15A est disposé à la deuxième extrémité 1B du câble de transport d'énergie électrique 1 pour recevoir le signal optique transmis par la fibre optique 13.

Un deuxième émetteur optique 15B associé au premier détecteur optique 17A est également disposé à la deuxième extrémité 1B du câble de transport d'énergie électrique 1 et est configuré pour transmettre un signal optique dans une fibre optique 13 vers la première extrémité 1A du câble de transport d'énergie électrique 1 pour être détecté par ce premier détecteur optique 17A.

Les deux signaux optiques peuvent être des signaux optiques continus, pulsés et/ou modulés. Ils peuvent être transmis par deux fibres optiques 13 distinctes ou peuvent être transmis par la même fibre optique 13 sur des longueurs d'onde différentes pour une meilleure discrimination ou sur les mêmes longueurs d'onde étant donné que leurs directions de propagation sont à contresens. Dans le cas d'une fibre optique 13 unique, le dispositif de détection 19 peut comprendre un premier 25A et un deuxième 25B circulateurs optiques. Le premier circulateur optique 25A est situé à une première extrémité de la fibre optique 13 au niveau de la première extrémité 1A du câble de transport d'énergie électrique 1 et est configuré pour transmettre le signal issu de la fibre optique 13 vers le premier détecteur optique 17A et pour transmettre le signal optique issu du premier émetteur optique 15A vers la fibre optique 13.

Le deuxième circulateur optique 25B est situé à une deuxième extrémité de la fibre optique 13 au niveau de la deuxième extrémité 1B du câble de transport d'énergie électrique 1 et est configuré pour transmettre le signal issu de la fibre optique 13 vers le deuxième détecteur optique 17B et pour transmettre le signal optique issu du deuxième émetteur optique 15B vers la fibre optique 13.

Ainsi, pour détecter un courant de court-circuit, on transmet des signaux optiques dans les deux directions, on mesure la valeur de l'angle de polarisation des signaux optiques transmis, plus exactement la variation de l'angle de polarisation, et lorsque la valeur de l'angle de polarisation varie d'une valeur supérieure à un seuil prédéterminé, on en déduit la présence d'un défaut dans le câble de transport d'énergie électrique 1.

Le seuil est choisi d'une part en fonction du nombre d'enroulements et du nombre de spires par enroulement et d'autre part en fonction d'une valeur typique de courant de court-circuit, par exemple supérieur à 10kA. Ainsi, des variations de courant qui se trouvent dans une plage normale de fonctionnement du câble 1 provoquent des variations d'angle de polarisation faibles en dessous du seuil et ne déclenchent pas d'alerte, alors qu'un courant de court-circuit dépassant par exemple 10kA peut être détecté facilement.

Pour des raisons de protection, il n'est pas nécessaire de connaître exactement la valeur du courant de court-circuit, mais seulement sa présence ou non.

Le dispositif de détection 19 comprend également un premier dispositif d'interruption 21A disposé à la première extrémité 1A du câble de transport d'énergie électrique 1 et associé au premier détecteur optique 17A et un deuxième dispositif d'interruption 21B disposé à la deuxième extrémité 1B du câble de transport d'énergie électrique 1 et associé au deuxième détecteur 17B.

Les dispositifs d'interruption 21A et 21B sont configurés pour permettre ou non la conduction du courant transmis vers et à partir du câble de transport d'énergie électrique 1.

Le dispositif de détection 19 comprend également une première unité de traitement 27A située au niveau de la première extrémité 1A du câble de transport d'énergie électrique 1 configurée pour traiter les signaux issus du premier détecteur optique 17A et une deuxième unité de traitement 27B située au niveau de la deuxième extrémité 1B du câble de transport d'énergie électrique 1 et configurée pour traiter les signaux issus du deuxième détecteur optique 17B. Les unités de traitement 27A et 27B sont par exemple réalisées par des microcontrôleurs ou des microprocesseurs.

Ainsi, les détecteurs optiques 17A et 17B et les unités de traitement associées 27A et 27B sont configurés pour détecter un décalage $\Delta\theta$ de l'angle de polarisation du signal optique transmis dans la fibre optique 13 supérieur à une valeur prédéterminée, par exemple un décalage supérieur à 20°. En effet, le passage du courant de court-circuit dans un enroulement E1, E2, E3 provoque une variation de l'angle de polarisation Δθ du signal optique qui est détectée par les détecteurs optiques 17A et 17B aux extrémités 1A et 1B du câble de transport d'énergie électrique 1.

Sur la figure 5, au niveau du premier détecteur optique 17A situé à la première extrémité 1A du câble de transport d'énergie électrique 1, on a représenté de façon schématique l'angle de polarisation détecté en fonction du temps avec deux fronts suivi d'un plateau correspondant chacun à un décalage Δθ de l'angle de polarisation du signal détecté. Le premier front est créé par le deuxième enroulement E2 et le deuxième front est créé par le premier enroulement E1 puisque les deux enroulements E1 et E2 sont situés entre la position du défaut et la position du premier détecteur optique 17A (un troisième front correspondant au troisième enroulement E3 peut également être détecté après les deux premiers pics puisque le courant de court-circuit se propage dans les deux directions).

Au niveau du deuxième détecteur optique 17B situé à la deuxième extrémité 1B du câble de transport d'énergie électrique 1, un front suivi d'un plateau créé par le troisième enroulement E3 est détecté (de la même manière deux autres fronts suivi d'un plateau correspondant aux enroulements E2 et E1 peuvent également être détectés par la suite - d'autres fronts suivront les premiers à cause des ondes de courant réfléchies aux extrémités du câble).

Lorsqu'un décalage Δθ de l'angle de polarisation du signal supérieur à un seuil prédéterminé est détecté par le premier détecteur optique 17A et la première unité de traitement 27A, la première unité de traitement 27A est configurée pour piloter l'ouverture du premier dispositif d'interruption 21A pour éviter la transmission du courant de court-circuit vers les autres équipements du réseau.

De la même manière, lorsqu'un décalage Δθ de l'angle de polarisation du signal supérieur à un seuil prédéterminé est détecté par le deuxième détecteur optique 17B et la deuxième unité de traitement 27B, la deuxième unité de traitement 27B est configurée pour piloter l'ouverture du deuxième dispositif d'interruption 21B.

Ainsi, en plaçant des détecteurs optiques 17A, 17B et des dispositifs d'interruption 21A, 21B à chaque extrémité 1A, 1B d'un câble de transport d'énergie électrique 1, il est possible de détecter un courant de court-circuit produit dans le câble de transport d'énergie électrique 1 et d'interrompre la connexion électrique avec le reste du réseau électrique avant la propagation du courant de court-circuit vers le reste du réseau électrique. Un câble de transport d'énergie électrique peut donc être donc être isolé de façon très rapide et efficace du réseau lorsqu'un défaut de court-circuit se présente.

La présente invention permet donc de protéger le réseau électrique en interrompant la connexion d'un câble de transport d'énergie électrique 1 lorsqu'un courant de court-circuit entraîne un décalage de l'angle de polarisation du signal optique supérieur à un seuil prédéterminé.

De plus, en cas d'absence de transmission d'un signal optique par la fibre optique 13, les unités de traitement 27A et 27B respectivement sont également configurées pour piloter l'ouverture des dispositifs d'interruption 21A et 21B respectivement. En effet, une absence de signal peut être provoquée par une dégradation du câble de transport d'énergie électrique 1 comme par exemple une section ou une entaille du câble de transport d'énergie électrique 1 qui peut également conduire à la formation d'un courant de court-circuit de sorte que l'ouverture des dispositifs d'interruption 21A, 21B permet d'empêcher la transmission de ce courant de court-circuit dans le reste du réseau.

En outre, en combinant, par des mesures à chaque extrémité du câble de transport d'énergie électrique 1, la méthode optique de détection décrite ci-dessus basée sur variation de l'angle de polarisation d'un signal optique transmis par la fibre optique 13 avec une méthode inductive de détection d'un défaut basée sur la mesure du courant transmis par l'âme centrale 3 à chaque extrémité, il est possible en comparant et mesurant les instants de détection pour chaque méthode de localiser le défaut, ce qui permet d'activer les dispositifs d'interruption nécessaires et suffisants pour protéger le réseau de transport de courant.

En effet, la vitesse de propagation du courant et notamment d'un défaut de court-circuit dans le câble de transport d'énergie électrique 1 est plus lente que la vitesse de propagation du signal optique dans la fibre optique 13. Pour une longueur de 50km, il résulte de la différence des vitesses de propagation un décalage de 10μs entre la réception du signal optique d'une part et l'arrivée du défaut au même endroit d'autre part. Ainsi, en connaissant les sens de propagation des signaux optiques et du défaut, on peut localiser par mesure de ce décalage dans le temps l'endroit où le défaut est survenu.

Pour cette raison, des détecteurs de courant 23A, 23B sont également placés à chaque extrémité 1A, 1B, du câble de transport d'énergie électrique 1 pour pouvoir détecter directement un courant, en particulier un courant de court-circuit transmis par le câble de transport d'énergie électrique 1. Ces détecteurs de courant 23A, 23B peuvent être utilisés pour déterminer la localisation du défaut dans le câble de transport d'énergie électrique 1. En effet, les détecteurs de courant 23A et 23B permettent de détecter un courant de court-circuit transmis. Un tel courant de court-circuit peut également être détecté par les détecteurs optiques 17A et 17B comme décrits précédemment. Les signaux optiques et le courant de court-circuit se déplaçant à des vitesses différentes, il est possible de déterminer la distance à la laquelle se trouve l'enroulement le plus proche du défaut à partir des instants de détection du courant de court-circuit via le détecteur optique 17A, 17B et via le détecteur de courant 23A, 23B associés à une extrémité d'un câble de transport d'énergie électrique. Le détecteur de courant 23A, 23B permet également de déterminer la direction de propagation du courant de court-circuit ce qui permet de déduire une localisation approximative du défaut, la précision dépendant de la distance entre deux enroulements de fibre optique 13.

Ainsi, en détectant à chaque extrémité du câble de transport d'énergie électrique 1 l'apparition d'un défaut d'une part par une méthode optique de détection basée sur variation de l'angle de polarisation d'un signal optique transmis par la fibre optique 13, et d'autre part par une méthode inductive basée sur la mesure du courant transmis par l'âme centrale 3, on peut localiser le défaut en tenant compte des instants de détection du défaut aux extrémités par la méthode optique de détection d'une part et par la méthode de détection inductive d'autre part.

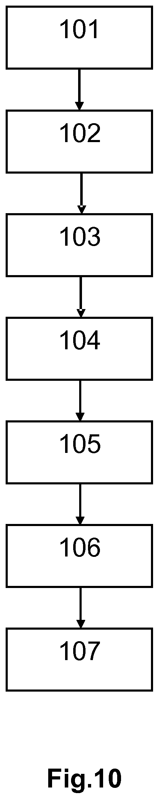

La figure 10 représente plus en détail un organigramme d'un mode de réalisation de différentes étapes du procédé de localisation d'un défaut. Certaines étapes peuvent être facultatives ou inversées.

Le procédé comprend une première étape 101 dans laquelle on transmet un signal optique dans la fibre optique 13 entre les deux extrémités du câble de transport d'énergie électrique 1. Le signal optique est transmis avec une polarisation initiale connue et prédéfinie. Il peut s'agir par exemple d'une polarisation linéaire présentant un angle de polarisation prédéfinie. La longueur d'onde du signal optique est choisie pour être compatible avec la fibre optique 13. Il peut par exemple s'agir d'une longueur d'onde dite de « télécommunication » dans l'infrarouge autour de 1,5μm par exemple qui minimise les pertes de transmission du signal optique.

La deuxième étape 102 est facultative et correspond à la mesure de l'angle de polarisation du signal optique transmis par un détecteur optique 17A, 17B. En effet, si la polarisation du signal optique est connu d'avance en fonction de la source de lumière utilisée, par exemple une diode laser, cette étape 102 n'est pas nécessaire. Alternativement, avant de coupler le signal optique dans la fibre optique 13, il est possible de passer le signal optique dans un filtre de polarisation qui définit l'angle de polarisation de sorte qu'en sortie de filtre, la polarisation est bien définie.

Une troisième étape 103 correspond à la mesure du courant et/ ou la variation du courant transmis par l'âme centrale 3 du câble de transport d'énergie électrique par un détecteur de courant 23A, 23B, ceci aux extrémités 1A et 1B du câble de transport d'énergie électrique 1. Cette mesure peut servir dans les conditions normales de fonctionnement à mesurer la quantité de courant transmis par le câble et en cas de défaut cela constitue un moyen supplémentaire de détection d'un défaut de court-circuit dans le câble de transport d'énergie électrique 1.

Une quatrième étape 104 concerne la détection d'une variation de l'angle de polarisation supérieure à un seuil prédéterminé par le détecteur optique 17A, 17B lorsqu'un défaut du câble de transport d'énergie électrique 1 provoque la transmission d'un courant de court-circuit.

Pour cette quatrième étape, il n'est pas forcément nécessaire de connaître par une mesure exacte la variation de l'angle de polarisation du signal transmis, mais il est seulement nécessaire de détecter qu'un angle de polarisation a été atteint ou franchi pour détecter qu'il y a eu un défaut dans le câble de transport d'énergie électrique 1.

Ainsi par exemple si l'angle de polarisation est à 0° à l'entrée 1A du câble de transport d'énergie électrique 1, et que par le dimensionnement de la ligne, le nombre de spires par enroulement, un défaut est par exemple une variation du courant de 10kA ou supérieur, une variation de 10kA correspondant à une variation de l'angle de polarisation de 57°, il suffit de placer au niveau du deuxième détecteur optique 17B à la sortie 1B du câble de transport d'énergie électrique 1 un filtre de polarisation de sortie tourné à cette valeur de 57° par rapport à l'angle de polarisation d'entrée du signal optique.

Si un défaut apparait, alors le deuxième détecteur optique 17B va pouvoir mesurer un signal de lumière lorsque l'angle de polarisation de la lumière a franchi 57°. La détection d'un signal par le détecteur optique 17B constitue dans ces conditions la preuve formelle qu'un défaut de court-circuit est intervenu.

Ceci correspond à une cinquième étape 105 relatif à la détection du courant de court-circuit transmis au niveau de l'âme centrale 3.

Une sixième étape 106 concerne par exemple la détermination de la direction de propagation du courant de court-circuit détecté. Certes, comme montré sur la figure 4, le courant de court-circuit se propage dans les deux sens et dans des sens de courant opposés comme représenté par les flèches F1 et F2, mais il est nécessaire au niveau par exemple du détecteur de courant 23A ou du premier détecteur optique 17A de déterminer si le défaut vient du câble de transport d'énergie électrique 1 ou d'un autre câble de transport d'énergie électrique auquel le câble de transport d'énergie électrique surveillé est raccordé à l'intérieur du même réseau de transport.

La septième étape 107 concerne la localisation de l'endroit où s'est produit le défaut en tenant compte des instants de détection du signal optique présentant une variation de l'angle de polarisation caractéristique d'un défaut de court-circuit, de la détection du courant de court-circuit et de la direction de propagation déterminée.

Ces différentes étapes peuvent être mises en œuvre pour les deux sens de propagation du défaut de court-circuit dans le câble de transport d'énergie électrique 1 et pour une pluralité voire tous les câbles de connexion 1 du réseau afin de localiser un défaut rapidement dans tout le réseau.

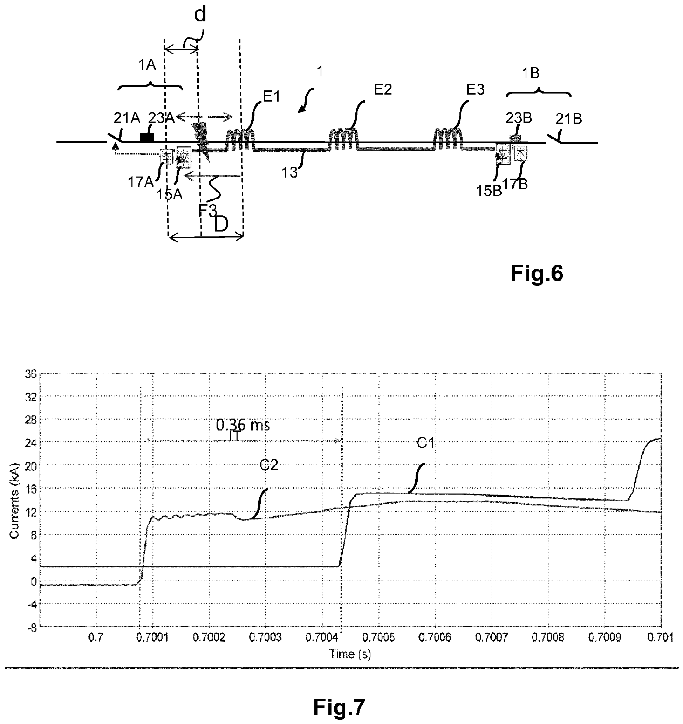

La figure 6 représente un exemple d'une situation où le défaut se produit dans un tronçon extrémal, c'est-à-dire entre une extrémité du câble de transport d'énergie électrique 1 et un enroulement, par exemple la première extrémité 1A et le premier enroulement E1.

On va distinguer par la suite la méthode optique de détection et la méthode inductive.

Concernant la méthode optique de détection, pour que celle-ci puisse être opérante, il est nécessaire que le défaut de court-circuit qui se propage dans les deux directions dans le câble de transport d'énergie électrique 1 atteigne d'abord un enroulement et puis que le signal optique porteur de l'information du défaut de courant par variation de l'angle de polarisation se propage vers un des détecteurs optiques 17A, 17B.

Dans le présent cas, l'enroulement est susceptible de détecter en premier le défaut de court-circuit est l'enroulement E1. Puis le chemin optique le plus court pour atteindre un détecteur optique 17A, 17B est indiqué par la flèche F3, c'est-à-dire par le signal optique polarisé injecté dans la fibre optique 13 par le deuxième émetteur optique 15B en direction du premier détecteur optique 17A. Le premier détecteur optique 17A pourra donc détecter un défaut de court-circuit correspondant au temps de parcours de l'endroit du défaut jusqu'à l'enroulement E1, puis le temps de parcours du signal optique en sens inverse de l'enroulement E1 vers le premier détecteur optique 17A.

Concernant la méthode de détection inductive basée sur la mesure de courant, le détecteur de courant 23A pourra détecter le défaut de court-circuit correspondant au temps de parcours du défaut dans le câble de transport d'énergie électrique 1 vers le détecteur 23A.

Dans les deux cas, on suppose pour des raisons de simplification que les détecteurs 17A et 23A sont très rapides, notamment par rapport au front du signal optique ou électromagnétique caractéristique d'un défaut de court-circuit.

Dans ce cas, on comprend aisément que le courant de court-circuit arrive à l'extrémité 1A du câble de transport d'énergie électrique 1 avant le signal optique de défaut de sorte que c'est le détecteur de courant 17A qui peut déclencher l'ouverture du dispositif d'interruption 21A pour empêcher une propagation du courant de court-circuit dans tout le réseau dans la mesure où le courant de court-circuit ne dépasse pas le pouvoir de coupure du dispositif d'interruption 21A.

De plus, la détection d'un défaut par le premier détecteur de courant 23A déclenche aussi l'envoi d'un signal optique de coupure (« intertripping » en anglais) en direction de l'extrémité 1B du câble de transport d'énergie électrique pour commander l'ouverture de l'interrupteur 21B afin d'isoler complètement le câble de transport d'énergie électrique 1.Ce signal de commande peut être envoyé par la fibre 13 en tant que commande (par exemple par une certaine modulation du signal optique) ou par une autre fibre de communication entre les extrémités 1A et 1B et situé à l'extérieur de l'écran métallique 7 et donc insensible au défaut de polarisation.

Bien entendu, comme il y a aussi un signal optique polarisé couplé par l'émetteur 15A dans la fibre optique 13 qui se propage depuis l'extrémité 1A vers l'extrémité 1B, le deuxième détecteur optique 17B va aussi détecter le défaut de court-circuit après un temps correspondant au temps de parcours du défaut de court-circuit vers l'enroulement E1, puis le temps de parcours du signal optique dans le même sens de l'enroulement E1 vers le deuxième détecteur optique 17B.

Enfin, à un certain moment, le deuxième détecteur de courant 23B va également détecter le défaut de court-circuit après un temps correspondant au temps de parcours du défaut de court-circuit depuis l'endroit du défaut vers le deuxième détecteur de courant 23B.

En tout cas, les unités de traitements 27A et 27B sont configurés pour

- commander l'ouverture de leur interrupteur associé 21A ou 21B à réception du premier signal reçu d'un défaut de court-circuit que ce soit un signal provenant d'un détecteur de courant, d'un détecteur optique ou d'un signal optique de coupure,
- envoyer un signal de coupure (« intertripping ») à l'autre extrémité du câble de transport d'énergie électrique 1 si le premier signal reçu d'un défaut de court-circuit est un signal provenant d'un détecteur de courant ou d'un détecteur optique.

Par ailleurs, la réception et l'analyse dans le temps des divers signaux reçus au niveau des extrémités 1A et 1B permet de localiser l'endroit du défaut de court-circuit. Cette localisation peut être grossière, par exemple pour savoir entre quels enroulements le défaut de court-circuit a eu lieu ou plus fine, par exemple en mesurant la distance entre l'endroit où le défaut est apparu et une des extrémités 1A et 1B.

Pour cela, la première unité de traitement 27A est également connectée au premier détecteur de courant 23A et est configurée pour analyser la chronologie des signaux reçus par le premier détecteur optique 17A et le premier détecteur de courant 23A et pour localiser l'endroit du défaut.

En effet, en déterminant la direction du courant de court-circuit grâce au premier détecteur de courant 23A et l'intervalle de temps entre le moment de la détection du défaut à partir du signal optique et le moment de la détection du défaut à partir du courant mesuré, il est possible de déterminer approximativement l'emplacement où le défaut est survenu.

Par exemple, la figure 7 représente un exemple de graphique chronologique de l'évolution au cours du temps des courbes C1 et C2 des courants détectés par le détecteur optique 17A (courbe C1) et par le détecteur de courant 23A (courbe C2) dans le cas représenté sur la figure 6.

Les enroulements E1, E2, E3 sont par exemple placés tous les 50 kilomètres. Le temps de propagation du courant sur 50 kilomètres est par exemple 0,26 ms tandis que le temps de propagation du signal optique sur 50 kilomètres est de 0,25 ms. Ainsi, si le défaut est situé à 15 kilomètres de la première extrémité 1A du câble de transport d'énergie électrique 1, le courant de court-circuit sera détecté par le détecteur de courant à environ 75µs après son apparition.

La détection du défaut de court-circuit par le détecteur optique intervient à 442µs (30km de parcours du défaut de court-circuit vers E1, puis 50km de parcours de E1 vers la première extrémité 1A).

On constate donc une différence ou décalage IT de 367µs.

Ainsi, en sachant que le signal de défaut de court-circuit mesuré par le détecteur de courant 23A a été reçu avant le signal de défaut de court-circuit mesuré par le détecteur optique 17A et tenant compte du décalage de réception des signaux dans le temps, il est possible de localiser l'endroit du défaut.

Du fait que le signal que le signal de défaut de court-circuit mesuré par le détecteur de courant 23A a été reçu avant le signal de défaut de court-circuit mesuré par le détecteur optique 17A, on sait que le défaut s'est produit dans une portion du câble de transport d'énergie électrique 1 située entre une extrémité et un premier enroulement.

Dans ce cas,

$$d = \frac{1}{2}(D - v_{CD}(\Delta t_{ext} - \frac{D}{v_{opt}})$$

où :

- d est la distance entre l'extrémité et l'endroit où le défaut de court-circuit s'est produit,
- D est la distance entre l'extrémité du câble de transport d'énergie électrique et le premier enroulement pour la détection optique,
- $v_{CD}$ est la vitesse de propagation du défaut de court-circuit dans le câble de transport d'énergie électrique 1,
- $v_{opt}$ est la vitesse de propagation d'un signal optique dans la fibre optique 13,
- $\Delta t_{ext}$ est le décalage mesuré entre l'instant de détection du défaut de court-circuit par détection optique et l'instant de détection du défaut de court-circuit par mesure de courant, le dernier intervenant avant l'instant de détection du défaut de court-circuit par détection optique.

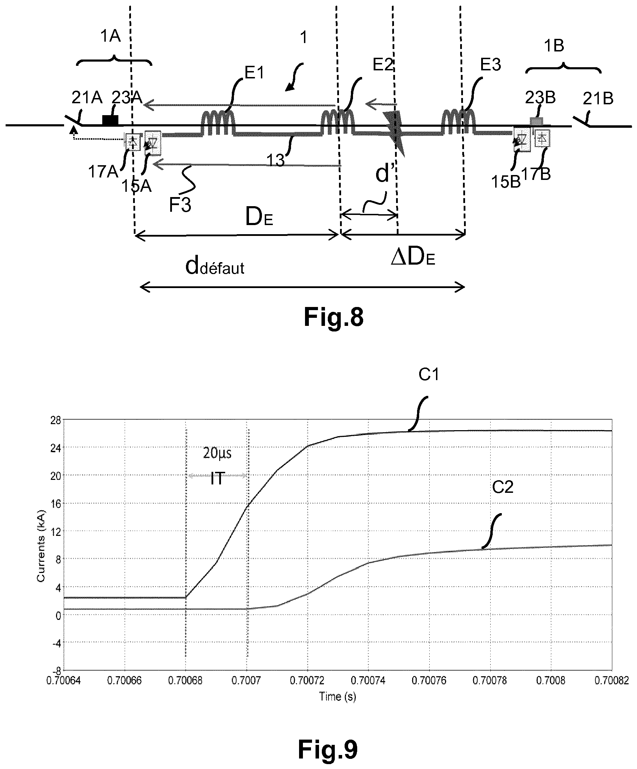

Dans le cas où le défaut survient à 135 kilomètres de la première extrémité 1A comme représenté sur la figure 8, le défaut est détecté par le signal optique 20µs avant l'arrivée du courant de court-circuit comme indiqué sur le graphique de la figure 9, ce qui permet d'une part, d'ouvrir le premier dispositif d'interruption 21A pour empêcher la propagation du courant de court-circuit et d'autre part, de déterminer l'emplacement du défaut à partir de ce décalage de temps de 20µs et du sens d'arrivée du signal de courant qui provient du câble de transport d'énergie électrique 1.

Plus précisément, le décalage dans le temps et l'analyse de la chronologie des signaux permet de détecter quel enroulement a détecté en premier le défaut de court-circuit et à quel distance cet enroulement se trouve de l'extrémité.

Dans ce cas,

$$D_E = (\Delta t * \frac{v_{opt}v_{CD}}{v_{CD} - v_{opt}})$$

où :

- $D_E$ est la distance entre l'extrémité et l'endroit où l'enroulement ayant été traversé en premier par le défaut de court-circuit qui s'est produit,
- $v_{CD}$ est la vitesse de propagation du défaut de court-circuit dans le câble de transport d'énergie électrique 1,
- $v_{opt}$ est la vitesse de propagation d'un signal optique dans la fibre optique 13,
- $\Delta t$ est le décalage mesuré entre l'instant de détection du défaut de court-circuit par détection optique et l'instant de détection du défaut de court-circuit par mesure de courant, le dernier intervenant après l'instant de détection du défaut de court-circuit par détection optique.

Ceci permet de localiser au niveau de quel enroulement (ici E2 en regardant la propagation des signaux optiques depuis l'extrémité 1B vers l'extrémité 1A) le défaut de court-circuit a pu être détecté en premier.

Pour déterminer plus précisément l'endroit où le défaut de court-circuit s'est produit, il est possible d'utiliser les signaux détectés à l'autre extrémité du câble et/ou les signaux optiques produit par les autres enroulements de fibre optique.

Ainsi, le défaut de court-circuit se propage dans les deux sens dans le câble de transport d'énergie. Il va donc aussi produire une variation de polarisation du signal optique qui peut être détectée par le premier détecteur optique 17A.

Soit $t_1$ le temps entre l'apparition du défaut électrique et l'instant de détection du défaut de court-circuit par détection optique, lorsque la variation de polarisation est générée par l'enroulement E2 :

$$t_1 = (\frac{d'}{v_{CD}} + \frac{D_E}{v_{opt}})$$

- le défaut s'est produit entre deux enroulements et d' est la distance entre l'endroit où le défaut de court-circuit s'est produit et l'enroulement proximal, c'est-à-dire l'enroulement qui se trouve le plus près du détecteur optique mesurant la variation de polarisation.

Soit $t_3$ le temps entre l'apparition du défaut électrique et l'instant de détection du défaut de court-circuit par détection optique, lorsque la variation de polarisation est générée par l'enroulement E3 :

$$t_3 = (\frac{\Delta D_E - d'}{v_{CD}} + \frac{D_E + \Delta D_E}{v_{opt}})$$

où $\Delta D_E$ est la distance entre les deux enroulements, ici E2 et E3 entre lesquels le défaut de court-circuit s'est produit.

Dans ce cas,

$$d' = \frac{1}{2}(\Delta D_E \frac{v_{opt} + v_{CD}}{v_{opt}} - \Delta t' v_{CD})$$

$$\Delta t' = t_3 - t_1$$

On peut donc déterminer avec précision que le défaut de court-circuit s'est produit à une distance $d_{défaut}$ = $D_E$ + d' du premier détecteur optique 17A disposé à la première extrémité 1A.

Par des raisonnements similaires, on peut aussi calculer la distance du défaut de la seconde extrémité et ainsi consolider le résultat.

On constate que la localisation peut se faire en utilisant seulement les signaux optiques.

La localisation de l'endroit permet aussi de faciliter les opérations de réparation du câble de transport d'énergie électrique 1.

Dans le cas d'un courant de court-circuit arrivant dans le sens inverse, il est possible de détecter la distance du défaut dans un câble de transport d'énergie électrique 1 adjacent.

Ainsi, l'utilisation d'un dispositif de détection 19 tel que décrit précédemment permet de détecter un courant de court-circuit se propageant dans un câble de transport d'énergie électrique 1 d'un réseau à courant continu à haute tension et de limiter la propagation du courant de court-circuit dans le reste du réseau par l'ouverture des dispositifs d'interruption 21A et 21B disposés aux extrémités du câble de transport d'énergie électrique 1 ce qui permet d'assurer la protection des équipements du réseau même lorsque le courant de court-circuit a une intensité supérieure à 20kA.

De plus, un tel dispositif de détection 19 peut être utilisé en combinaison avec l'utilisation d'inductances disposées aux extrémités des câbles de connexion 1 pour limiter l'amplitude du courant de court-circuit puisque la détection du courant de court-circuit est effectué au niveau des enroulements de fibre optique 13 et ne se fait pas au niveau des extrémités du câble de transport d'énergie électrique 1.

Enfin l'identification d'un défaut de court-circuit par la méthode optique est bien plus facile car la variation du courant à l'intérieur du câble, au plus près du défaut de court-circuit, est plus importante que la variation de courant qui peut être mesurée aux extrémités du câble de transport d'énergie électrique 1, notamment par via des inductances aux extrémités.

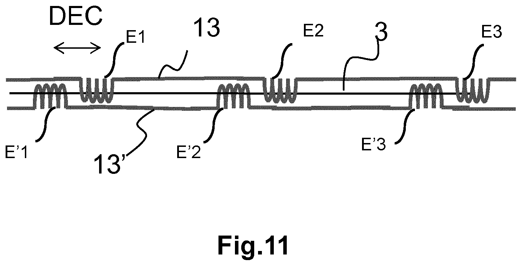

Selon encore un autre développement représenté à la figure 11 de façon simplifié avec seulement l'âme centrale conductrice 3 , on prévoit d'équiper le câble de transport d'énergie électrique 1 d'une première fibre 13 avec une première pluralité d'enroulement E1, E2 et E3 définissant chacun une zone de détection et une seconde fibre 13' avec une seconde pluralité d'enroulement E'1, E'2 et E'3 définissant chacun également une zone de détection. Bien entendu, chaque fibre optique 13, 13' est équipée à ses extrémités d'émetteurs et de récepteurs comme décrits ci-dessus mais qui ne sont pas représentés sur la figure 11. Les enroulements E1, E2 et E3 de la première fibre 13 sont décalés d'une distance DEC des enroulements E'1, E'2 et E'3 de la seconde fibre optique 13'. Ceci permet de fiabiliser davantage la détection des défauts de courant de court-circuit.

## Revendications

1. Dispositif de détection (19) d'un courant de court-circuit dans un câble de transport d'énergie électrique (1) comprenant :

   - un câble de transport d'énergie électrique (1) pour réseau haute tension à courant continu comprenant :

     • une âme centrale (3) conductrice électriquement configurée pour transmettre un courant électrique,
     • une enveloppe isolante (5) électriquement disposée autour de l'âme centrale (3),
     • un écran métallique (7) disposé autour de l'enveloppe isolante (5),
     et dans lequel le câble de transport d'énergie électrique (1) comprend également au moins une fibre optique (13) s'étendant le long du câble de transport d'énergie électrique dans lequel, dans au moins une zone de détection du câble de transport d'énergie électrique (1), ladite au moins une fibre optique (13) est disposée entre l'âme centrale (3) conductrice électriquement et l'écran métallique (7) en formant des enroulements (E1, E2, E3) autour de l'âme centrale (3),

     - un premier émetteur optique (15A) disposé à une première extrémité (1A) du câble de transport d'énergie électrique (1) et configuré pour transmettre un signal optique dans une première fibre optique (13) dudit câble de transport d'énergie électrique (1),

- un deuxième émetteur optique (15B) disposé à une deuxième extrémité (1B) du câble de transport d'énergie électrique (1) et configuré pour transmettre un signal optique dans la première ou une autre fibre optique (13) dudit câble de transport d'énergie électrique (1),

- un premier détecteur optique (17A) disposé à la première extrémité (1A) du câble de transport d'énergie électrique (1) et configuré pour détecter un changement de l'angle de polarisation du signal optique transmis par le deuxième émetteur optique (15B) et associé à un signal de défaut,

- un premier dispositif d'interruption (21A) disposé à la première extrémité (1A) du câble de transport d'énergie électrique, couplé au premier détecteur optique (17A) et configuré pour interrompre la connexion du câble de transport d'énergie électrique (1) lorsqu'un changement de l'angle de polarisation par rapport à un angle de référence supérieur à une valeur prédéterminée est détecté par le premier détecteur optique (17A),

- un deuxième détecteur optique (17B) disposé à la deuxième extrémité (1B) du câble de transport d'énergie électrique (1) et configuré pour détecter un changement de l'angle de polarisation du signal optique transmis par le premier émetteur optique (15A) et associé à un signal de défaut,

- un deuxième dispositif d'interruption (21B) disposé à la deuxième extrémité (1B) du câble de transport d'énergie électrique (1), couplé au deuxième détecteur optique (17B) et configuré pour interrompre la connexion du câble de transport d'énergie électrique (1) lorsqu'un changement de l'angle de polarisation par rapport à un angle de référence supérieur à une valeur prédéterminée est détecté par le deuxième détecteur optique (17B).

2. Dispositif de détection (19) selon la revendication 1 dans lequel le premier (21A), respectivement le deuxième (21B), dispositif d'interruption est également configuré pour interrompre la connexion du câble de transport d'énergie électrique en l'absence de réception d'un signal optique par le premier détecteur optique (17A), respectivement par le deuxième détecteur optique (17B).

3. Dispositif de détection (19) selon la revendication 1 ou 2 dans lequel le premier émetteur optique (15A) étant configuré pour transmettre un signal à une première longueur d'onde et le deuxième émetteur optique (15B) étant configuré pour transmettre un signal à une deuxième longueur d'onde distincte de la première longueur d'onde.

4. Dispositif de détection (19) selon l'une des revendications 1 à 3 comprenant également :

- un premier détecteur de courant (23A) disposé à la première extrémité (1A) du câble de transport d'énergie électrique (1) et configuré pour détecter un signal de défaut électrique transmis par le câble de transport d'énergie électrique (1),

- une première unité de traitement (27A) disposé à la première extrémité (1A) du câble de transport d'énergie électrique (1) et couplée au premier détecteur optique (17A) et au premier détecteur de courant (23A) et configurée pour déterminer d'une part une direction du signal de défaut électrique reçu et d'autres part un décalage temporel entre l'instant de réception du signal de défaut électrique et l'instant de réception du signal de défaut optique et pour localiser une zone de défaut à partir de la direction du signal de défaut électrique et de l'instant de réception des signaux de défaut optiques et électriques,

- un deuxième détecteur de courant (23B) disposé à la deuxième extrémité (1B) du câble de transport d'énergie électrique (1) et configuré pour détecter un signal de défaut électrique transmis par le câble de transport d'énergie électrique (1),

- une deuxième unité de traitement (27B) disposé à la deuxième extrémité (1B) du câble de transport d'énergie électrique (1) et couplée au deuxième détecteur optique (17B) et au deuxième détecteur de courant (23B) et configurée pour déterminer d'une part une direction du signal de défaut électrique reçu et d'autres part un décalage temporel entre l'instant de réception du signal de défaut électrique et l'instant de réception du signal de défaut optique et pour localiser une zone de défaut à partir de la direction du signal de défaut électrique et de l'instant de réception des signaux de défaut optiques et électriques.

5. Dispositif de détection selon l'une quelconque des revendications précédentes dans lequel la zone de détection se situe au niveau d'un tronçon (P1, P4, P7) du câble de transport d'énergie électrique (1).

6. Dispositif de détection selon l'une quelconque des revendications 1 à 4 dans lequel la zone de détection se situe au niveau d'une jonction (C1, C3, C6) du câble de transport d'énergie électrique (1).

7. Dispositif de détection selon l'une quelconque des revendications précédentes, dans lequel le pas (L) d'enroulement des spires de la fibre optique (13) a une longueur égale à au moins trois fois le diamètre (D) de l'enveloppe isolante (5) sur laquelle est enroulée la fibre optique (13).

8. Dispositif de détection selon l'une quelconque des revendications précédentes dans lequel la longueur d'un enroulement (E1, E2, E3) de la fibre optique (13) à l'intérieur de l'écran métallique (7) est comprise entre 100 et 2000 mètres.

9. Dispositif de détection selon l'une quelconque des revendications précédentes dans lequel un enroulement (E1, E2, E3) de la fibre optique (13) comprend au moins 80 spires.

10. Dispositif de détection selon l'une quelconque des revendications précédentes dans lequel une pluralité d'enroulements (E1, E2, E3) de la fibre optique (13) sont ménagés sur une pluralité de tronçons du câble de transport d'énergie électrique (1), deux enroulements (E1, E2, E3) successifs de la fibre optique (13) étant séparés d'une distance comprise entre 10 et 300 kilomètres.

11. Dispositif de détection selon l'une quelconque des revendications précédentes d'énergie électrique (1) selon l'une des revendications précédentes dans lequel il comprend une première fibre optique avec une première pluralité d'enroulements (E1, E2, E3) et une seconde fibre optique avec une seconde pluralité d'enroulements (E1, E2, E3), les enroulements de la première fibre optique étant décalés d'une distance prédéfinie des enroulements de la seconde fibre optique.

12. Dispositif de détection selon l'une quelconque des revendications précédentes dans lequel la fibre optique (13) est une fibre monomode.

13. Dispositif de détection selon l'une quelconque des revendications précédentes comprenant une pluralité de tronçons (P1, P2...P7) de câble de transport d'énergie électriques, deux tronçons de câble de transport d'énergie électrique (1) consécutifs étant reliés entre eux par des jonctions et dans lequel certains premiers tronçons (P1, P4, P7) comprennent des enroulements (E1, E2, E3) de leur longueur.

14. Dispositif de détection la revendication 13, dans lequel dans des deuxièmes tronçons (P2, P3, P5, P6), la fibre optique (13) est disposée à l'extérieur de l'écran métallique (7).

15. Dispositif de détection la revendication 13, dans lequel dans des deuxièmes tronçons (P2, P3, P5, P6), la fibre optique (13) est disposée à l'intérieur de l'écran métallique (7) avec un pas d'enroulement au moins 10 fois plus grand que pour les premiers tronçons (P1, P4, P7).

16. Dispositif de détection la revendication 13, dans lequel dans des deuxième tronçons (P2, P3, P5, P6), la fibre optique (13) est disposée à l'intérieur de l'écran métallique (7) sans s'enrouler autour de l'âme centrale (3) conductrice électriquement, notamment avec des ondulations.

17. Procédé de détection d'un défaut de court-circuit dans un réseau haute tension à courant continu, le réseau comprenant au moins un dispositif de détection (19) selon l'une quelconque des revendications précédentes, ledit procédé comprenant les étapes suivantes :

- depuis une première extrémité (1A) du câble de transport d'énergie électrique (1), on transmet un signal optique dans une première fibre optique (13) dudit câble de transport d'énergie électrique (1),
- depuis une deuxième extrémité (1B) du câble de transport d'énergie électrique (1) on transmet un signal optique dans la première ou une autre fibre optique (13) dudit câble de transport d'énergie électrique (1),
- on détecte à la première extrémité (1A) du câble de transport d'énergie électrique (1) un changement de l'angle de polarisation du signal optique transmis depuis la deuxième extrémité (1B) et associé à un signal de défaut,
- on interrompt la connexion du câble de transport d'énergie électrique (1) lorsqu'un changement de l'angle de polarisation par rapport à un angle de référence supérieur à une valeur prédéterminée est détecté à la première extrémité (1A) du câble de transport,
- on détecte à la deuxième extrémité (1B) du câble de transport d'énergie électrique (1) un changement de l'angle de polarisation du signal optique transmis depuis la première extrémité (1A) et associé à un signal de défaut,
- on interrompt la connexion du câble de transport d'énergie électrique (1) lorsqu'un changement de l'angle de polarisation par rapport à un angle de référence supérieur à une valeur prédéterminée est détecté à la deuxième extrémité (1A) du câble de transport.

**Patentansprüche**

1. Kurzschlussstrom-Meldevorrichtung (19) in einem Stromleiter, umfassend:

- ein Stromleiter (1) für ein Hochspannungs-Gleichstromnetz, umfassend

• einen stromleitenden zentralen Kern (3), der so gestaltet ist, dass er elektrischen Strom überträgt,

• einem elektrisch isolierenden Mantel (5), der um den zentralen Kern (3) angeordnet ist,

• eine metallische Abschirmung (7), die um den isolierenden Mantel (5) herum angeordnet ist,

und wobei der Stromleiter (1) auch mindestens einen Lichtwellenleiter (13) umfasst, der sich entlang des Stromleiters erstreckt, wobei in mindestens einem Detektionsbereich des Stromleiters (1) mindestens ein Lichtwellenleiter (13) zwischen dem stromleitenden zentralen Kern (3) und der metallischen Abschirmung (7) angeordnet ist und Wicklungen (E1, E2, E3) um den zentralen Kern (3) bilden

- einen ersten Lichtsender (15A), der an einem ersten Ende (1A) des Stromleiters (1) angeordnet und so ausgebildet ist, dass er ein optisches Signal in einem ersten Lichtwellenleiter (13) des jeweiligen Stromleiters (1) sendet,
- einen zweiten Lichtsender (15B), der an einem zweiten Ende (1B) des Stromleiters (1) angeordnet und so ausgebildet ist, dass er ein Lichtsignal in dem ersten oder in einem anderen Lichtwellenleiter (13) des Stromleiters (1) sendet,
- einen ersten Lichtdetektor (17A), der am ersten Ende (1A) des Stromleiters (1) angeordnet und so ausgebildet ist, dass er eine Änderung des Polarisationswinkels des vom zweiten Lichtsender (15B) übertragenen und mit einem Fehlersignal verbundenen Lichtsignals erfasst,
- eine erste Unterbrechungsvorrichtung (21A), die an dem ersten Ende (1A) des Stromleiters angeordnet ist, mit dem ersten Lichtdetektor (17A) verbunden und so ausgebildet ist, dass sie die Verbindung des Stromleiters (1) unterbricht, wenn eine Änderung des Polarisationswinkels in Bezug auf einen Nennwinkel, der größer als ein vorbestimmter Wert ist, durch den ersten Lichtdetektor (17A) gemeldet wird,
- einen zweiten Lichtdetektor (17B), der am zweiten Ende (1B) des Stromleiters (1) angeordnet und so ausgebildet ist, dass er eine Änderung des Polarisationswinkels des vom ersten Lichtsender (15A) übertragenen und mit einem Fehlersignal verbundenen Lichtsignals meldet,
- eine zweite Unterbrechungsvorrichtung (21B), die am zweiten Ende (1B) des Stromleiters (1) angeordnet ist, mit dem zweiten Lichtdetektor (17B) verbunden und so ausgebildet ist, dass sie die Verbindung des Stromleiters (1) unterbricht, wenn eine Änderung des Polarisationswinkels in Bezug auf einen Nennwinkel, der größer als ein vorbestimmter Wert ist, durch den zweiten Lichtdetektor (17B) gemeldet wird.

2. Detektionsvorrichtung (19) nach Anspruch 1, wobei die erste (21A) bzw. die zweite (21B) Unterbrechungsvorrichtung auch so ausgebildet ist, dass sie die Verbindung des Stromleiters bei fehlendem Empfang eines Lichtsignals durch den ersten Lichtdetektor (17A) bzw. durch den zweiten Lichtdetektor (17B) unterbricht.

3. Detektionsvorrichtung (19) nach Anspruch 1 oder 2, wobei der erste Lichtsender (15A) so ausgebildet ist, dass er ein Signal mit einer ersten Wellenlänge sendet, und der zweite Lichtsender (15B) so konfiguriert ist, dass er ein Signal mit einer zweiten Wellenlänge sendet, die sich von der ersten Wellenlänge unterscheidet.

4. Detektionsvorrichtung (19) nach einem der Ansprüche 1 bis 3, ferner umfassend:

- einen ersten Stromdetektor (23A), der am ersten Ende (1A) des Stromleiters (1) angeordnet und so ausgebildet ist, dass er ein durch den Stromleiter (1) übertragenes elektrisches Fehlersignal meldet,
- eine erste Verarbeitungseinheit (27A), die am ersten Ende (1A) des Stromleiters (1) angeordnet ist und mit dem ersten Lichtdetektor (17A) und dem ersten Stromdetektor (23A) verbunden und ausgebildet ist, um einerseits eine Richtung des empfangenen Strom-Fehlersignals und andererseits einen zeitlichen Versatz zwischen dem Zeitpunkt des Empfangs des Strom-Fehlersignals und dem Zeitpunkt des Empfangs des Licht- Fehlersignals zu bestimmen und einen Fehlerbereich aus der Richtung des Strom-Fehlersignals und ab dem Zeitpunkt des Empfangs der Licht- und Strom-Fehlersignale zu orten,
- einen zweiten Stromdetektor (23B), der am zweiten Ende (1B) des Stromleiters (1) angeordnet und so ausgebildet ist, dass er ein durch den Stromleiter (1) übertragenes Strom-Fehlersignal meldet,
- eine zweite Verarbeitungseinheit (27B), die am zweiten Ende (1B) des Stromleiters (1) angeordnet ist und mit dem zweiten Lichtdetektor (17B) und dem zweiten Stromdetektor (23B) verbunden und so ausgebildet ist, dass sie einerseits eine Richtung des empfangenen Strom-Fehlersignals und andererseits einen zeitlichen Versatz zwischen dem Empfangszeitpunkt des Empfangs des Strom-Fehlersignals und dem Zeitpunkt des optischen Fehlersignals bestimmt und einen Fehlerbereich aus der Richtung des Strom-Fehlersignals und ab dem Zeitpunkt des Empfangs der Licht und Stromfehlersignale zu orten.

5. Detektionsvorrichtung nach einem der vorhergehenden Ansprüche, bei der sich der Meldebereich auf der Höhe eines Abschnitts (P1, P4, P7) des Stromleiters (1) befindet.

6. Detektionsvorrichtung nach einem der Ansprüche 1 bis 4, wobei sich der Meldebereich an einer Verbindungsstelle (C1, C3, C6) des Stromleiters (1) befindet.

7. Detektionsvorrichtung nach einem der vorhergehenden Ansprüche, wobei die Steigung (L) der Wicklung der Lichtwellenleiterwindungen (13) eine Länge hat, die mindestens dem Dreifachen des Durchmessers (D) des isolierenden Mantels (5) entspricht, auf den der Lichtwellenleiter (13) gewickelt ist.

8. Detektionsvorrichtung nach einem der vorhergehenden Ansprüche, wobei die Länge einer Wicklung (E1, E2, E3) des Lichtwellenleiters (13) innerhalb der metallischen Abschirmung (7) zwischen 100 und 2000 Metern beträgt.

9. Detektionsvorrichtung nach einem der vorhergehenden Ansprüche, wobei eine Wicklung (E1, E2, E3) des Lichtwellenleiters (13) mindestens 80 Windungen aufweist.

10. Detektionsvorrichtung nach einem der vorhergehenden Ansprüche, bei der mehrere Windungen (E1, E2, E3) des Lichtwellenleiters (13) auf mehreren Abschnitten des Stromleiters (1) vorgesehen sind, wobei zwei aufeinanderfolgende Windungen (E1, E2, E3) des Lichtwellenleiters (13) durch einen Abstand zwischen 10 und 300 Kilometern getrennt sind.

11. Detektionsvorrichtung (1) nach einem der vorhergehenden Ansprüche, **dadurch gekennzeichnet, dass** sie einen ersten Lichtwellenleiter mit einer ersten Mehrzahl von Windungen (E1, E2, E3) und einen zweiten Lichtwellenleiter mit einer zweiten Mehrzahl von Windungen (E1, E2, E3) aufweist, wobei die Windungen des ersten Lichtwellenleiters um einen vorgegebenen Abstand zu den Windungen des zweiten Lichtwellenleiters versetzt sind.

12. Detektionsvorrichtung nach einem der vorhergehenden Ansprüche, wobei der Lichtwellenleiter (13) eine Monomode-Faser ist.

13. Detektionsvorrichtung nach einem der vorhergehenden Ansprüche mit mehreren Abschnitten (P1, P2, .... P7) eines Stromleiters, wobei zwei aufeinanderfolgende Abschnitte des Stromleiters (1) durch Abzweigungen miteinander verbunden sind und wobei bestimmte erste Abschnitte (P1, P4, P7) über ihre gesamte Länge Wicklungen (E1, E2, E3) eines Lichtwellenleiters (13) zwischen dem isolierenden Mantel (5) und der metallischen Abschirmung (7) umfassen.

14. Detektionsvorrichtung nach Anspruch 13, wobei in zweiten Abschnitten (P2, P3, P5, P6) der Lichtwellenleiter (13) außerhalb der metallischen Abschirmung (7) angeordnet ist.

15. Detektionsvorrichtung nach Anspruch 13, wobei in zweiten Abschnitten (P2, P3, P5, P6) der Lichtwellenleiter (13) innerhalb der metallischen Abschirmung (7) mit einer mindestens 10-fach größeren Windungssteigung als bei den ersten Abschnitten (P1, P4, P7) angeordnet ist.

16. Detektionsvorrichtung nach Anspruch 13, wobei in zweiten Abschnitten (P2, P3, P5, P6) des Lichtwellenleiters (13) innerhalb der metallischen Abschirmung (7) ohne Wicklung um den stromleitenden zentralen Kern (3), insbesondere mit Wellungen, angeordnet ist.

17. Verfahren zum Melden eines Kurzschlussfehlers in einem Hochspannungs-Gleichstromnetz, wobei das Netz mindestens eine Detektionsvorrichtung (19) nach einem der vorhergehenden Ansprüche umfasst, wobei das Verfahren die folgenden Schritte umfasst:

- von einem ersten Ende (1A) des Stromleiters (1) wird ein Lichtsignal in einem ersten Lichtwellenleiter (13) des Stromleiters (1) übertragen,
- von einem zweiten Ende (1B) des Stromleiters (1) ein Lichtsignal in dem ersten oder in einem anderen Lichtwellenleiter (13) des Stromleiters (1) übertragen wird,
- eine Änderung des Polarisationswinkels des Lichtsignals wird am ersten Ende (1A) des Stromleiters (1) gemeldet, der vom zweiten Ende (1B) übertragenen und mit einem Fehlersignal verbunden ist,
- die Verbindung des Stromleiters (1) wird unterbrochen, wenn am ersten Ende (1A) des Stromleiters eine Änderung des Polarisationswinkels in Bezug auf einen Nennwinkel, der größer als ein vorbestimmter Wert ist, gemeldet wird,
- eine Änderung des Polarisationswinkels der vom ersten Ende (1A) übertragenen Lichtsignals wird am zweiten Ende (1B) des Stromleiters (1) gemeldet und mit einem Fehlersignal verbunden,
- die Verbindung des Stromleiters (1) wird unterbrochen, wenn am zweiten Ende (1A) des Stromleiters eine Änderung des Polarisationswinkels in Bezug auf einen Nennwinkel, der größer als ein vorbestimmter Wert ist, gemeldet wird.

**Claims**

1. Device (19) for detecting a short circuit current in an electrical power transmission cable (1) comprising:

   - An electrical power transmission cable (1) for high voltage direct current network comprising:

     • an electrically conducting central core (3) configured for transmitting an electrical current,
     • an insulating envelope (5) electrically disposed around a central core (3),
     • a metallic screen (7) disposed around the insulating envelope (5),

   - wherein the electrical power transmission cable (1) also contains at least one optical fibre (13) extending along the electrical power transmission cable in which, in at least one detection zone of the electrical power transmission cable (1), the said at least one optical fibre (13) is disposed between
   - the electrically conducting central core (3) and the metallic screen (7) forming windings (E1 > E2> E3) around the central core (3),
   - a first optical emitter (15A) disposed at the first end (1A) of the electrical power transmission cable (1) and configured to transmit an optical signal in a first optical fibre (13) of the said electrical power transmission cable (1),
   - a second optical emitter (15B) disposed at the second end (1B) of the electrical power transmission cable (1) and configured to transmit an optical signal in the first optical fibre or another optical fibre (13) of the said electrical power transmission cable (1),
   - a first optical detector (17A) disposed at the first end (1A) of the electrical power transmission cable (1) and configured to detect a change in the polarisation angle of the optical signal transmitted by the second optical emitter (15B) and associated with a fault signal,
   - a first interrupting device (21A) disposed at the first end (1A) of the electrical power transmission cable, coupled with the first optical detector (17A) and configured to interrupt the connection of the electrical power transmission cable (1) when a change in the polarisation angle with respect to a reference angle greater than a predetermined value is detected by the first optical detector (17A),

     - a second optical detector (17B) disposed at the second end (1B) of the electrical energy transmission cable (1) and configured to detect a change in the polarisation angle of the optical signal transmitted by the first optical emitter (15A) and associated with a fault signal,
     - a second interrupting device (21B) disposed at the second end (1B) of the electrical power transmission cable (1), coupled with the second optical detector (17B) and configured to interrupt the connection of the electrical power transmission cable (1) when a change in the polarisation angle with respect to a reference angle greater than a pre-determined value is detected by the second optical detector (17B).

2. Detection device (19) according to claim 1 wherein the first (21A), respectively the second (21B) interrupting device is also configured to interrupt the connection of the electrical power transmission cable in the absence of reception of an optical signal by the first optical detector (17A), respectively by the second optical detector (17B).

3. Detection device (19) according to claim 1 or 2 wherein the first optical emitter (15A) is configured to transmit a signal with a first wavelength and the second optical emitter (15B) is configured to transmit a signal with a second wavelength distinct from the first wavelength.

4. Detection device (19) according to one of claims 1 to 3 also comprising:

   - a first current emitter (23A) disposed at the first end (1A) of the electrical power transmission cable (1) and configured to detect an electrical fault signal transmitted by the electrical power transmission cable (1),
   - a first processing unit (27A) disposed at the first end (1A) of the electrical power transmission cable (1) and coupled with a first optical detector (17A) and with the first current detector (23A) and configured to determine a direction of an electrical fault signal received, and by a time difference between the moment of reception of the electrical fault signal and the moment of reception of the optical fault signal and to localise a fault zone from the direction of the electrical fault signal and the moment of reception of the optical and electrical fault signals,
   - a second current emitter (23B) disposed at the second end (1B) of the electrical power transmission cable (1) and configured to detect an electrical fault signal transmitted by the electrical power transmission cable (1),
   - a second processing unit (27B) disposed at the second end (1B) of the electrical power transmission cable (1) and coupled with a second optical detector (17A) and with the second current detector (23B) and configured to determine on the one hand a direction of an electrical fault signal received, and on the other hand a time difference between the moment of reception of the electrical fault signal and the moment of reception of the optical fault signal and to localise a fault zone from the direction of the electrical fault signal and the moment of reception of the optical and electrical fault signals.

5. Detection device according to any of the preceding claims wherein the detection zone is located in a section (P1, P4, P7) of the electrical power transmission cable (1).

6. Detection device according to any of preceding claims 1 to 4 wherein the detection zone is located at a junction (C1, C3, C6) of the electrical power transmission cable (1).

7. Detection device according to any of the preceding claims, wherein the winding pitch (L) of the optical fibre (13) has a length equal to least three times the diameter (D) of the insulating envelope (5) on which the optical fibre (13) is wound.

8. Detection device according to any of the preceding claims wherein the length of a winding (E1, E2, E3) of the optical fibre (13) inside the metallic screen (7) is between 100 and 2,000 metres.

9. Detection device according to any of the preceding claims wherein a winding (E1, E2, E3) of the optical fibre (13) contains at least 80 turns.

10. Detection device according to any of the preceding claims wherein a plurality of windings (E1, E2, E3) of the optical fibre (13) are arranged on a plurality of sections of the electrical power transmission cable (1), two successive windings (E1, E2, E3) of the optical fibre (13) being separated by a distance of between 10 and 100 kilometres.

11. Detection device according to any of the preceding claims of electrical power (1) according to any of the preceding claims wherein it contains a first optical fibre with a first plurality of windings (E1, E2, E3) and a second optical fibre with a second plurality of windings (E1, E2, E3), the windings of the first optical fibre being offset a pre-defined distance from the windings of the second optical fibre.

12. Detection device according to any of the preceding claims wherein the optical fibre (13) is a single mode fibre.

13. Detection device according to any of the preceding claims containing a plurality of sections (P1, P2...P7) of electrical power transmission cable, two consecutive sections of the electrical power transmission cable (1) being connected to each other by junctions and wherein certain first sections (P1, P4, P7) contain windings (E1, E2, E3) of optical fibre (13) between the insulating envelope (5) and the metallic screen (7) over their entire length.

14. Detection device according to claim 13 wherein in the second sections (P2, P3, P5, P6), the optical fibre (13) is disposed outside the metallic screen (7).

15. Detection device according to claim 13 wherein in the second sections (P2, P3, P5, P6), the optical fibre (13) is disposed inside the metallic screen (7) with a winding pitch at least 10 times greater than for the first sections (P1, P4, P7).

16. Detection device according to claim 13 wherein in the second sections (P2, P3, P5, P6), the optical fibre (13) is disposed inside the metallic screen (7) without being wound around the electrically conducting central core (3), in particular with undulations.

17. Process for detecting a short circuit fault in a high voltage direct current network, the network containing at least one detection device (19) according to any of the preceding claims, the said process comprising following steps:

- from a first end (1A) of the electrical power transmission cable (1), an optical signal is transmitted in a first optical fibre (13) of the said electrical power transmission cable (1),
- from a second end (1B) of the electrical power transmission cable (1), an optical signal is transmitted in a first or another fibre (13) of the said electrical power transmission cable (1),
- at the first end (1A) of the electrical power transmission cable (1), a change is detected in the polarisation angle of the optical signal transmitted from the second end (1B) and associated with a fault signal,
- the connection to the electrical power transmission cable (1) is interrupted when a change in the angle of polarisation relative to a reference angle greater than a pre-determined value is detected at the first end (1A) of the transmission cable,
- at the second end (1B) of the electrical power transmission cable (1), a change is detected in the polarisation angle of the optical signal transmitted from the first end (1A) and associated with a fault signal,
- the connection to the electrical power transmission cable (1) is interrupted when a change in the angle of polarisation relative to a reference angle greater than a pre-determined value is detected at the second end (1A) of the transmission cable.

**Fig.1 A**

**Fig.1 B**

**Fig.2**

**Fig.3A**

13

3

P2

**Fig.3B**

C1

P1

7

3

7A

P2

7

**Fig.3C**

13

5

**Fig.4**

**Fig.5**

Fig.6

Fig.7

Fig.8

Fig.9

Fig.10

**Fig.11**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2687830
- DE 19544778